# EUROPÄISCHE PATENTSCHRIFT

(11) **EP 3 129 703 B1**
(45) Veröffentlichungstag und Bekanntmachung des Hinweises auf die Patenterteilung: **28.02.2018**
(21) Anmeldenummer: 15712335.7
(22) Anmeldetag: 23.03.2015
(51) Int. Cl.: F21S 8/10, H01S 5/00, F21K 99/00, F21W 101/02, F21Y 101/00, F21V 7/04, F21V 9/16, F21V 13/02, H01S 5/02, F21K 9/64, F21Y 115/30, F21Y 115/10, H01S 5/323

(54) **LEUCHTVORRICHTUNG MIT LICHTQUELLE UND BEABSTANDETEM LEUCHTSTOFFKÖRPER**
LUMINAIRE WITH LIGHT SOURCE AND SPACED-APART LUMINESCENT BODY
DISPOSITIF D'ÉCLAIRAGE POURVU D'UNE SOURCE DE LUMIÈRE ET ÉLÉMENT LUMINESCENT PLACÉ À DISTANCE

(30) Priorität: 11.04.2014 DE 102014207024
(43) Veröffentlichungstag der Anmeldung: 15.02.2017
(73) Patentinhaber: OSRAM GmbH, 80807 München (DE)
(72) Erfinder: HAGER, Jürgen, 89542 Herbrechtingen (DE); SCHWAIGER, Stephan, 89081 Ulm (DE); HERING, Oliver, 89168 Niederstotzingen (DE)
(86) Internationale Anmeldenummer: PCT/EP2015/056138
(87) Internationale Veröffentlichungsnummer: WO 2015/154983

(56) Entgegenhaltungen:
- EP-A2- 2 461 090
- EP-A2- 2 541 129
- WO-A1-2013/094221
- WO-A2-2010/004477
- DE-A1-102012 005 660
- DE-A1-102012 220 472
- DE-A1-102012 220 481
- US-A1- 2008 074 879
- US-A1- 2012 051 078

## Beschreibung

Die Erfindung betrifft eine Leuchtvorrichtung, aufweisend mindestens eine Lichtquelle, insbesondere Halbleiterlichtquelle, zur Aussendung eines Primärlichtstrahls auf mindestens einen beabstandeten Leuchtstoffkörper. Die Erfindung betrifft auch einen Fahrzeugscheinwerfer, welcher mindestens eine solche Leuchtvorrichtung aufweist. Die Erfindung betrifft ferner ein Fahrzeug, das mindestens einen solchen Fahrzeugscheinwerfer aufweist. Die Art des Fahrzeugs ist grundsätzlich nicht beschränkt und mag luft-, wasser- und/oder landgestützte Fahrzeuge umfassen, insbesondere Kraftfahrzeuge, insbesondere Krafträder, Pkw oder Lkw. Die Erfindung ist insbesondere anwendbar auf Kraftfahrzeugscheinwerfer. Die Erfindung ist insbesondere anwendbar auf Lichtquellen in Form von Lasern, insbesondere Halbleiterlasern. Die Erfindung ist insbesondere anwendbar auf LARP-Scheinwerfer.

Es sind sog. LARP ("Laser Activated Remote Phosphor")-Scheinwerfer bekannt, bei denen von mindestens einer Laserlichtquelle ausgesandtes Primärlicht auf ein Konversionselement oder Leuchtstoffkörper trifft und davon zumindest teilweise in Sekundärlicht längerer Wellenlänge umgewandelt wird. Das von dem Leuchtstoffkörper ausgesandte Sekundärlicht oder Mischlicht (aus dem nicht umgewandelten Primärlicht und dem umgewandelten Sekundärlicht) wird als Nutzlicht zur Bildung eines Lichtabstrahlmusters des LARP-Scheinwerfers verwendet. Zur Strahlformung des Lichtabstrahlmusters ist dem Leuchtstoffkörper mindestens ein optisches Element nachgeschaltet, z.B. mindestens eine Linse, mindestens ein Reflektor und/oder mindestens eine Blende.

Die Druckschrift EP 2 541 129 A2 offenbart einen solchen Scheinwerfer.

Kommt es zu Schädigungen an dem Leuchtstoffkörper oder sogar zu einer Entfernung des Leuchtstoffkörpers, beispielsweise durch eine thermische Überlastung und/oder häufige Stöße, wird der Primärlichtstrahl zumindest teilweise direkt auf das mindestens eine nachgeschaltete optische Element treffen und als konzentrierter Lichtstrahl aus dem LARP-Scheinwerfer austreten. Dieser konzentrierte Lichtstrahl mag eine so hohe Strahlungsintensität aufweisen, dass es bei Betrachtung des Scheinwerfers durch einen Menschen in wenigen Fällen zu starken Blendungen oder Schädigungen, besonders der Augen und der Haut, kommen könnte.

Es ist die **Aufgabe** der vorliegenden Erfindung, die Nachteile des Standes der Technik zumindest teilweise zu überwinden und insbesondere eine Leuchtvorrichtung mit mindestens einer Lichtquelle, insbesondere Halbleiterlichtquelle, mit nachgeschaltetem Leuchtstoffkörper bereitzustellen, die einen besonders sicheren Betrieb auch bei Schädigung oder Verlust des Leuchtstoffkörpers ermöglicht.

Diese Aufgabe wird gemäß den Merkmalen der unabhängigen Ansprüche gelöst. Bevorzugte Ausführungsformen sind insbesondere den abhängigen Ansprüchen entnehmbar.

Die Aufgabe wird gelöst durch eine Leuchtvorrichtung, aufweisend mindestens eine Lichtquelle zur Aussendung eines Primärlichtstrahls auf mindestens einen beabstandeten Leuchtstoffkörper, wobei der Leuchtstoffkörper mindestens ein durchgehendes Loch aufweist und ein Direktlichtanteil des jeweiligen Primärlichtstrahls durch das mindestens eine Loch durchstrahlbar ist.

Diese Leuchtvorrichtung weist den Vorteil auf, dass sie thermisch besonders stabil ist, ein vielgestaltiges Lichtabstrahlmuster erzeugen kann und eine hohe Sicherheit für den Fall einer ungewollten Schädigung des Leuchtstoffs oder sogar eines Verlusts des Leuchtstoffkörpers bietet.

Dadurch, dass ein Teil des Primärlichtstrahls (nämlich der "Direktlichtanteil") praktisch wechselwirkungsfrei durch den Leuchtstoffkörper hindurchgeleitet wird, wird eine Erwärmung des Leuchtstoffkörpers durch Wellenlängenkonversion reduziert. Dies hält eine Konversionseffizienz hoch und reduziert eine Alterung des Leuchtstoffkörpers. Die reduzierte Alterung wiederum vermindert die Wahrscheinlichkeit, dass sich der Leuchtstoffkörper oder Teile davon ablösen.

Der Direktlichtanteil lässt sich zudem anders formen als das durch von dem Leuchtstoffkörper abgestrahlte Konversionslicht, wodurch sich die Möglichkeit zur Erzeugung besonders vielgestaltiger Lichtabstrahlmuster ergibt.

Beispielsweise können das Konversionslicht und der Direktlichtanteil unterschiedliche Funktionen erfüllen. In einer Variante mag mittels des Konversionslichts ein herkömmliches Lichtabstrahlmuster erzeugt werden, z.B. ein Abblendlicht oder Fernlicht eines Kraftfahrzeugs, während der Direktlichtanteil spezielle Bereiche davon partiell erhellt. Der Direktlichtanteil mag auch in Abhängigkeit von dem gewählten Lichtabstrahlmuster durchgelassen oder blockiert werden, beispielsweise mittels einer schaltbaren Blende bzw. eines "Shutters".

Der Sicherheitsaspekt kann beispielsweise dadurch erfüllt werden, dass der Direktlichtanteil der Leuchtvorrichtung weitgehend getrennt von dem Konversionslicht führbar und damit auch zur Verminderung seiner Strahlungsintensität beeinflussbar ist. Sollte der Leuchtstoffkörper ganz oder teilweise geschädigt oder entfernt werden (z.B. durch mechanische Belastung, Alterung usw.), ergibt sich kein undefinierter oder unerwünschter Lichtpfad für den sich dann ungehindert ausbreitenden Primärlichtstrahl. Vielmehr läuft dieser Primärlichtstrahl dann auf dem Lichtpfad des Direktlichtanteils und wird dabei ohne weitere Maßnahmen ebenfalls intensitätsgemindert. Dieser Lichtpfad lässt sich einfach an den Fall einer Schädigung oder Entfernung des Leuchtstoffkörpers anpassen, so dass für einen Nutzer dann keine Gefahr besteht, z.B. in Bezug auf seine Fläche.

Die Lichtquelle mag insbesondere eine Halbleiterlichtquelle sein, z.B. eine Leuchtdiode oder eine Laserdiode. Jedoch ist die Lichtquelle nicht darauf beschränkt, sondern mag z.B. auch eine andere Art von Laser oder eine andere Art Lichtquelle, welche vorzugsweise kohärentes oder stark gebündeltes Licht erzeugt, sein.

Der mindestens einen Lichtquelle mag eine Primäroptik zugeordnet sein, die zwischen der Lichtquelle selbst und dem Leuchtstoffkörper angeordnet ist. Sie mag beispielsweise dazu dienen, den von der mindestens einen Lichtquelle emittierten Primärlichtstrahl vorzuformen, z.B. in seiner Intensität zu homogenisieren, ihn zu fokussieren, aufzuweiten, zu parallelisieren usw. Auch mag die Primäroptik dazu dienen, eine Querschnittsform des Primärlichtstrahls zu ändern, z.B. von einer ursprünglich elliptischen Form in eine kreisrunde Form. Dies mag insbesondere durch Primäroptiken in Form von Kollimatoren mit Glasfasern, Freiform-Kollimationslinsen, Systemen aus mehreren (nicht rotationsymmetrischen) asphärischen Sammellinsen usw. geschehen. Jedoch mag grundsätzlich auch der ursprünglich emittierte Primärlichtstrahl bereits eine im Querschnitt kreisrunde Form aufweisen. Eine asymmetrische, z.B. elliptische, Querschnittsform des auf den Leuchtstoffkörper einfallenden Primärlichtstrahls mag besonders einfach umsetzbar sein, z.B. durch einfache Linsen mit nur einer Halbleiterlichtquelle.

Der Leuchtstoffkörper weist einen oder mehrere Konversionsstoffe oder Leuchtstoffe auf, welche das einfallende Primärlicht zumindest teilweise in jeweiliges Sekundärlicht längerer Wellenlänge umwandeln (Down-Konversion) oder auch in Sekundärlicht kürzerer Wellenlängen (Up-Konversion). Das von dem Leuchtstoffkörper abgestrahlte Konversionslicht mag also praktisch reines Sekundärlicht oder ein Mischlicht mit Anteilen von Primärlicht und Sekundärlicht sein. Beispielsweise mag das Mischlicht eine in Summe blaugelbe bzw. weiße Mischung aus blauem Primärlicht und durch einen blau-gelb konvertierenden Leuchtstoff erzeugtes gelbes Sekundärlicht sein. Ein Konversionsgrad lässt sich beispielsweise mittels einer Konzentration des Leuchtstoffs und/oder einer Dicke des Leuchtstoffkörpers einstellen. Bevorzugt ist der Konversionsgrad über seine Fläche konstant, jedoch ist der Leuchtstoffkörper nicht darauf beschränkt.

Der Leuchtstoffkörper ist bevorzugt ein lagen- oder schichtartiger Körper mit einer Dicke, welche erheblich (z.B. eine Größenordnung) geringer ist als seine ebene Ausdehnung. Ein solcher schichtartiger Leuchtstoffkörper mag beispielsweise auf ein lichtdurchlässiges Substrat (z.B. einen Saphirkörper) aufgedruckt oder aufgesprüht worden sein oder als Plättchen vorgefertigt und dann auf ein Substrat aufgeklebt worden sein. Der Leuchtstoffkörper mag insbesondere in Form eines keramischen Leuchtstoffs vorliegen. Eine Außenkontur des schichtartigen Leuchtstoffkörpers mag beispielsweise rund (z.B. kreisrund oder elliptisch), eckig (z. B. quadratisch oder rechteckig) und/oder freiförmig geformt sein.

Dass der Leuchtstoffkörper mindestens ein Loch aufweist, mag umfassen, dass in dem Leuchtstoffkörper mindestens eine durchgehende Aussparung vorhanden ist.

Der Leuchtstoffkörper mag einstückig oder mehrstückig hergestellt worden sein. Bei der einstückigen Herstellung mag das mindestens eine Loch bereits bei der Herstellung der Grundform eingebracht sein (z.B. durch eine Nichtbelegung einer entsprechenden Fläche mit Leuchtstoff) oder nachträglich eingebracht werden (z.B. durch Materialabtrag). Bei einem mehrstückig hergestellten Leuchtkörper wist dieser aus mehreren zuvor separat hergestellten Einzelteilen zusammengesetzt worden. Ein Loch mag auch hier durch Materialabtrag nachträglich eingebracht worden sein. Alternativ mögen zumindest zwei der Einzelteile eine Lücke zwischen sich aufweisen. Beispielsweise kann ein mittiges Loch in einem kreisrunden Leuchtstoffkörper durch Zusammensetzen tortenartiger Einzelstücke erreicht werden, denen die Spitze fehlt.

Der Leuchtstoffkörper mag beispielsweise ein eigenständig tragfähiger Körper sein, z.B. ein keramisches Leuchtstoffplättchen, oder mag z.B. eine auf einem lichtdurchlässigen Träger, z.B. einem Saphir-Plättchen, befindliche Beschichtung sein.

Es ist eine Ausgestaltung, dass das mindestens eine Loch mittig oder in einem mittigen Bereich des Leuchtstoffkörpers angeordnet ist, was eine Kühlung des Leuchtstoffkörpers erleichtert. Dabei wird ausgenutzt, dass der Leuchtstoffkörper insbesondere an seinem Rand befestigt und so thermisch angebunden ist, um die durch die Wellenlängenkonversion erzeugte Verlustwärme (Stokes-Wärme) abzuführen.

Durch das mindestens eine Loch in der Mitte erreicht man einen thermisch besonders günstigen Aufbau, da nun der Teil des Leuchtstoffkörpers, der thermisch am stärksten belastet wäre (nämlich die Mitte), keine Wärme mehr erzeugt. Die Bereiche des Leuchtstoffkörpers, die weiter weg von der Mitte liegen, sind grundsätzlich besser an die thermische Schnittstelle am Rand des Leuchtstoffkörpers angebunden und erfahren typischerweise bei Verwendung eines Lasers als Lichtquelle auch einen geringeren Leistungseintrag, weil eine Leistungsdichte eines Laserstrahls (typischerweise im Querschnitt gaußähnlich verteilt) im Zentrum deutlich höher als am Rand ist.

Insgesamt erzeugt der Leuchtstoffkörper also insbesondere breitstrahlendes Konversionslicht und erlaubt den Durchtritt eines oder mehrerer schmalerer Direktlichtanteile bzw. Direktlichtstrahlen.

Das Loch oder die Löcher können grundsätzlich eine beliebige Form annehmen bzw. bei mehreren Löchern auch beliebig zueinander angeordnet sein. Das Loch mag z.B. als Kreisloch, elliptisches Loch, Ring oder als ein länglicher Schlitz ausgebildet sein. Die Löcher können beispielsweise sternförmig, kreisförmig umlaufend, elliptisch umlaufend, polygonal umlaufend, gitterförmig, oder stochastisch verteilt an dem Leuchtstoffkörper angeordnet sein. Die Verteilung der Flächengröße der individuellen Löcher kann dergestalt ausgeführt werden, dass die Summe aller Einzelflächen einem vorgegebenen Wert entspricht. Der Leuchtstoff kann als Leuchtstoffschicht beispielsweise auf einem reflektierenden Träger oder einem lichtdurchlässigen Träger, z.B. einem Saphirplättchen, aufgebracht sein.

Ein einziges Loch mag beispielsweise vorteilhaft sein, wenn nur ein einziger Primärlichtstrahl auf den Leuchtstoffkörper einfällt, insbesondere falls dieser eine im Querschnitt deutlich ungleichmäßige Intensitätsverteilung aufweist. Mehrere Löcher mögen beispielsweise vorteilhaft sein, wenn mehrere Primärlichtstrahlen auf den Leuchtstoffkörper einfallen oder wenn ein Primärlichtstrahl breit ist und eine vergleichmäßigte Intensitätsverteilung aufweist. So lässt sich durch die Zahl der Löcher bei einem breiten und vergleichmäßigten Primärlichtstrahl ein Verhältnis zwischen dem Direktlichtanteil und dem auf den Leuchtstoffkörper einfallen Anteil genau einstellen.

Der Leuchtstoffkörper und insbesondere das mindestens eine Loch mögen durch das Primärlicht senkrecht oder schräg bestrahlt werden. Bei einer schrägen Einstrahlung des Primärlichts mag das mindestens eine Loch so geformt sein, dass es die bei Projektion auf eine Ebene senkrecht zu dem einfallenden Primärlichtstrahl gewünschte Form aufweist. In anderen Worten kann das mindestens eine Loch so geformt sein, dass es eine Verzerrung durch die Schrägstellung zu dem Primärlichtstrahl ausgleicht.

Es ist eine Ausgestaltung, dass der Direktlichtanteil einen Teil höchster Leistungsdichte des Primärlichtstrahls umfasst, beispielsweise definiert als Bereich, an dessen äußerer Begrenzung die Intensität auf 50% oder auf 1/e (mit e der eulerschen Zahl), einer Zentrumsintensität abgefallen ist. So kann ein Strahlanteil besonders hoher Strahlungsintensität ungefährlich gemacht werden. Es ist noch eine Ausgestaltung, dass der Direktlichtanteil im Querschnitt einem inneren Bereich des Primärlichtstrahls entspricht. Durch diese Ausgestaltung(en) können insbesondere von einer Halbleiterlichtquelle wie einem Laser oder einer Leuchtdiode stammende Strahlanteile kritisch hoher Strahlungsintensität besonders effektiv ungefährlich gemacht werden.

Es ist eine weitere Ausgestaltung, dass von der Leuchtvorrichtung abgestrahltes Direktlichtanteil maximal einer Laserklasse 2, insbesondere maximal einer Laserklasse 1 entspricht, z.B. gemäß Norm EN 60825-1 oder DIN VDE 0837. Mittels einer Einstellung auf die Laserklasse 2 lässt sich eine Augensicherheit in allen praktisch vorkommenden Fällen herstellen, mit Einstellung der Laserklasse 1 auch bei genauerer Inspektion der Leuchtvorrichtung auf kurze Entfernungen.

Es ist noch eine weitere Ausgestaltung, dass der Direktlichtanteil bei symmetrischer Querschnittsform einen halben Öffnungswinkel zwischen 0,5° und 15° aufweist. Dadurch lässt sich der Strahlanteil besonders hoher Strahlungsintensität insbesondere auch von herkömmlichen Lasern als Direktlichtanteil durch das mindestens eine Loch hindurchstrahlen.

Es ist auch eine Ausgestaltung, dass der Direktlichtanteil bei asymmetrischer Querschnittsform des Primärlichtstrahls einen kleinsten halben Öffnungswinkel zwischen 0,5° und 15° und einen größten halben Öffnungswinkel von maximal zwischen 1,5° und 30° aufweist. Insbesondere ist der größte halbe Öffnungswinkel vorteilhafterweise bis zu einem Faktor 3 größer als der kleinste halbe Öffnungswinkel. Dadurch lässt sich der Strahlanteil besonders hoher Strahlungsintensität insbesondere auch von herkömmlichen Lasern mit elliptischer Querschnittsform des Primärlichtstrahls als Direktlichtanteil durch das mindestens eine Loch hindurchstrahlen.

Es ist auch eine Ausgestaltung, dass das von dem Leuchtstoffkörper abgestrahlte Konversionslicht und der Direktlichtanteil zumindest im Wesentlichen optisch separat geführt sind. Dies mag insbesondere bedeuten, dass eine Strahlformung des Direktlichtanteils oder des Konversionslichts den jeweils anderen Lichtanteil nicht wesentlich beeinflusst. So mag beispielsweise eine Absorption des Direktlichtanteils keinen oder einen nur geringen Einfluss auf das durch das Konversionslicht erzeugte Lichtabstrahlmuster haben. Eine geringe Beimischung von Konversionslicht zu dem Direktlichtanteil mag praktisch vernachlässigbar sein. Dadurch kann der Direktlichtanteil eigenständig und zumindest weitgehend unabhängig von dem Konversionslicht behandelt werden.

Es ist insbesondere dazu eine Ausgestaltung, dass der Direktlichtanteil nur auf mindestens eine erste optische Fläche trifft und das Konversionslicht auf mindestens eine zweite optische Fläche trifft. So kann der Direktlichtanteil auf einfache Weise eigenständig beeinflusst werden, ohne dass von der ersten optischen Fläche als Nutzlicht abgestrahltes Konversionslicht davon wesentlich beeinflusst ist. In einer Variante kann die zweite optische Fläche wie eine herkömmliche optische Fläche beispielsweise eines Scheinwerfers ausgebildet sein, z.B. als ein Schalenreflektor. Die erste optische Fläche ist insbesondere so ausgestaltet, dass sie die Strahlungsintensität des Direktlichtanteils reduziert.

Es ist eine Weiterbildung, dass die erste optische Fläche eine größere Fläche aufweist als eine durch den Direktlichtanteil bestrahlte Teilfläche davon. So wird erreicht, dass bei einer Beschädigung oder einem Verlust des Leuchtstoffkörpers zumindest ein Teil des dann nicht mehr umgewandelten Primärlichts oder Primärlichtanteils auch auf die erste optische Fläche trifft und dadurch in seiner Strahlungsintensität besonders stark verringert wird. Alternativ mag durch den Direktlichtanteil praktisch die gesamte erste optische Fläche bestrahlbar sein. Dies mag vorteilhaft sein, wenn bei einer Beschädigung oder einem Verlust des Leuchtstoffkörpers das dann nicht mehr umgewandelte Primärlicht bereits so schwach ist, dass es auch bei einer Bestrahlung der zweiten optischen Fläche bereits unter einem vorbestimmten Schwellwert der Strahlungsintensität bleibt.

Die erste optische Fläche mag insbesondere von der zweiten optischen Fläche unterscheidbar geformt und/oder ausgerichtet sein. Sie mag also insbesondere nicht nur ein begrenzter Teilbereich einer ansonsten einheitlich geformten optischen Fläche sein. Die unterscheidbare Form mag beispielsweise eine andere Grundform (z.B. sphärisch anstelle von elliptisch, elliptisch anstelle von paraboloid usw.) und/oder einen anderen Krümmungswinkel umfassen. Die unterscheidbare Form mag zusätzlich oder alternativ eine unterschiedliche Oberflächenbeschaffenheit umfassen. Die unterscheidbare Ausrichtung mag beispielsweise eine Anwinkelung von erster und zweiter optischer Fläche umfassen. Auch mag die Unterscheidbarkeit durch eine räumliche Trennung oder Beabstandung der ersten und zweiten optischen Fläche umgesetzt sein.

Die erste optische Fläche mag beispielsweise lichtabsorbierend ausgebildet sein, was eine besonders hohe Augensicherheit ermöglicht. Sie kann alternativ spiegelnd reflektierend sowie strahlaufweitend ausgebildet sein, wodurch sich der Direktlichtanteil noch gezielt zur Bildung des Lichtabstrahlmusters verwenden lässt, z.B. zur Aufhellung eines entsprechenden Bereichs des Lichtabstrahlmusters, z.B. mit blauem Primärlicht. Sie kann auch diffus reflektierend ausgebildet sein, was eine geringere Aufwärmung erzeugt als eine Absorption und zudem noch eine Streulichtbeleuchtung des Umfelds ermöglicht, z.B. für eine verbesserte seitliche Sichtbarkeit mit geringer Strahlintensität.

Die erste optische Fläche mag in noch einer Weiterbildung teilweise lichtabsorbierend und teilweise reflektierend sein. Sie mag auch teilweise diffus reflektierend und teilweise spekular reflektierend sein.

Die erste optische Fläche mag eine einzige, vollflächig lichtabsorbierend und/oder reflektierend ausgebildete Fläche sein.

Die erste optische Fläche mag alternativ eine zusammenhängende lichtabsorbierende und/oder reflektierende Fläche sein, welche ein oder mehrere innere Aussparungen aufweist. Sie mag dann z.B. ringförmig oder gitterartig ausgebildet sein.

Die erste optische Fläche mag aber auch mehrere nicht zusammenhängende lichtabsorbierende und/oder reflektierende Teilbereiche aufweisen, z.B. in Form eines Streifenmuster, eines Matrixmusters, eines ringförmigen Musters, eines unregelmäßigen Punktmusters usw.

Die mindestens eine erste optische Fläche ist aufgrund des typischerweise sehr viel schmaleren Öffnungswinkels des Strahls des Direktlichtanteils im Vergleich zu dem Konversionslicht in der Regel sehr viel kleiner als die zweite optische Fläche. Daher wird eine Funktion der zweiten optischen Fläche durch die erste optische Fläche nur geringfügig bis praktisch nicht beeinflusst.

Es ist ferner eine Ausgestaltung, dass die mindestens eine erste optische Fläche in Bezug auf den Leuchtstoffkörper vor der mindestens einen zweiten optischen Fläche angeordnet ist, also insbesondere einen geringeren Abstand zu dem Leuchtstoffkörper aufweist als die zweite optische Fläche. Dadurch kann die Größe der ersten optischen Fläche besonders klein gehalten werden, insbesondere bei einem vergleichsweise stark divergenten Direktlichtanteil.

Es ist außerdem eine Ausgestaltung, dass die mindestens eine erste optische Fläche hinter einer Aussparung in der mindestens einen zweiten optischen Fläche angeordnet ist. Dies ermöglicht eine besonders einfache räumliche Trennung des Direktlichtanteils von dem Konversionslicht. Speziell mag so ein mittels des Konversionslichts erzeugtes Lichtabstrahlmuster durch den Direktlichtanteil besonders wenig beeinflusst werden.

Es ist auch eine Ausgestaltung, dass die mindestens eine erste optische Fläche und die mindestens eine zweite optische Fläche einem gemeinsamen Bauteil zugehörig sind. Dies erleichtert eine Herstellung und Montage der Leuchtvorrichtung.

Es ist eine alternative Ausgestaltung, dass die mindestens eine erste optische Fläche und die mindestens eine zweite optische Fläche unterschiedlichen Bauteilen zugehörig sind. So wird eine besonders vielgestaltige Formung und Anordnung der optischen Flächen ermöglicht.

Es ist zudem eine Ausgestaltung, dass das von dem Leuchtstoffkörper abgestrahlte Konversionslicht und der Direktlichtanteil in ein refraktives optisches Element einstrahlbar sind.

Es ist noch eine Ausgestaltung, dass die Leuchtvorrichtung ein Fahrzeugscheinwerfer oder ein Teil davon ist.

Die Aufgabe wird auch gelöst durch einen Fahrzeugscheinwerfer, welcher mindestens eine solche Leuchtvorrichtung aufweist. Der Fahrzeugscheinwerfer mag beispielsweise ein Scheinwerfer eines Kraftfahrzeugs sein. Er mag z.B. ein Abblendlicht, ein Fernlicht, ein Nebellicht, ein Kurvenlicht und/oder ein Tagfahrlicht erzeugen.

Die Aufgabe wird auch gelöst durch ein Fahrzeug, das mindestens einen solchen Fahrzeugscheinwerfer aufweist. Die Art des Fahrzeugs ist grundsätzlich nicht beschränkt und mag luft-, wasser- und/oder landgestützte Fahrzeuge umfassen, insbesondere Kraftfahrzeuge, insbesondere Pkw oder Lkw.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden schematischen Beschreibung von Ausführungsbeispielen, die im Zusammenhang mit den Zeichnungen näher erläutert werden. Dabei können zur Übersichtlichkeit gleiche oder gleichwirkende Elemente mit gleichen Bezugszeichen versehen sein.
- Fig.1: zeigt als Schnittdarstellung in Seitenansicht eine Leuchtvorrichtung gemäß einem ersten Ausführungsbeispiel;
- Fig.2: zeigt einen Reflektor der Leuchtvorrichtung gemäß dem ersten Ausführungsbeispiel in einer Ansicht von vorne;
- Fig.3: zeigt als Schnittdarstellung in Seitenansicht eine Leuchtvorrichtung gemäß einem zweiten Ausführungsbeispiel;
- Fig.4: zeigt einen Reflektor der Leuchtvorrichtung gemäß dem zweiten Ausführungsbeispiel in einer Ansicht von vorne;
- Fig.5: zeigt als Schnittdarstellung in Seitenansicht eine Leuchtvorrichtung gemäß einem dritten Ausführungsbeispiel; und
- Fig.6: zeigt als Schnittdarstellung in Seitenansicht eine Leuchtvorrichtung gemäß einem vierten Ausführungsbeispiel.

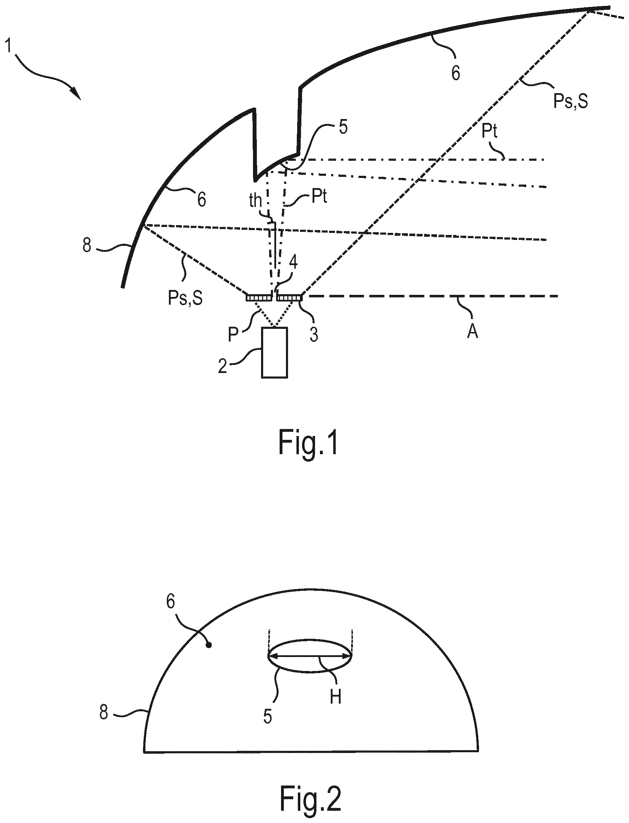

**Fig.1** zeigt eine Leuchtvorrichtung in Form eines Fahrzeugscheinwerfers 1 mit einer Lichtquelle in Form eines Lasers 2, der einen blauen Primärlichtstrahl P senkrecht auf einen davon beabstandeten dünnen, scheibenförmigen Leuchtstoffkörper 3 abstrahlt, z.B. eine Leuchtstoffschicht oder ein keramisches Leuchtstoffplättchen. Der Laser 2 mag z.B. als eine Laserdiode realisiert sein. In dem Leuchtstoffkörper 3 befindet sich Leuchtstoff zur zumindest teilweisen Wellenlängenkonversion des blauen Primärlichtstrahls P in gelbes Sekundärlicht S. Dadurch kann von dem Leuchtstoffkörper 3 Konversionslicht Ps, S in Form von weißem bzw. blau-gelbem Mischlicht als eine Überlagerung des Sekundärlichts S mit durch den Leuchtstoffkörper 3 hindurchlaufendem, ggf. gestreutem Primärlicht Ps abgestrahlt werden. Das Konversionslicht Ps, S ist vergleichsweise breitstreuend.

Der Laser 2 und der Leuchtstoffkörper 3 sind hier in einer Durchlichtanordnung aufgebaut, bei welcher das von der dem einfallenden Primärlichtstrahl P abgewandten Seite des Leuchtstoffkörper 3 abgestrahlte Konversionslicht Ps, S als Nutzlicht verwendet wird. Jedoch ist auch ein reflektiver Aufbau möglich.

Der Leuchtstoffkörper 3 weist ein mittiges Loch 4 auf, dessen Querschnitt kleiner ist als ein Querschnitt des Primärlichtstrahls P. Der Primärlichtstrahl P strahlt so auf das Loch 4, dass ein Anteil (der im Folgenden als "Direktlichtanteil" Pt bezeichnet wird) des Primärlichtstrahls P durch das Loch 4 hindurchstrahlt. Spezieller strahlt der Primärlichtstrahl P so auf das Loch 4, dass der Direktlichtanteil Pt im Querschnitt dem Bereich des Primärlichtstrahls P mit der höchsten Leistungsdichte oder Strahlungsintensität entspricht. Anstelle eines Lochs 4 können auch mehrere Löcher vorhanden sein. Eine Größe und/oder eine Form des mindestens einen Lochs 4 kann in einem weiten Bereich variiert werden.

Durch eine Variation beispielsweise der Lochgröße, der Zahl der Löcher und von weiteren Eigenschaften des Leuchtstoffkörpers 3 wie einer Dotierung des Leuchtstoffs, einer Streuzentrendichte und/oder einer Dicke lässt sich die Lasersicherheit bzw. die Laserklasse einstellen.

Auf der dem einfallenden Primärlichtstrahl P abgewandten Seite des Leuchtstoffkörpers 3 bleibt also ein anteiliger Lichtstrahl oder Kernstrahl als Direktlichtanteil Pt erhalten, welcher die gleiche Strahlrichtung aufweist wie der Primärlichtstrahl P. Eine Querschnittsform des Direktlichtanteils Pt mag z.B. kreisförmig oder oval (insbesondere elliptisch) sein.

Ein halber Öffnungswinkel th des Direktlichtanteils Pt mag bei kreisförmiger Querschnittsform des Direktlichtanteils Pt bevorzugt zwischen 0,5° und 15° liegen. Bei einer ovalen Querschnittsform des Direktlichtanteils Pt mag insbesondere ein kleinster halber Öffnungswinkel th (an der kleinen Halbachse) zwischen 0,5° und 15° und ein größter halber Öffnungswinkel th (an der größten Halbachse) zwischen 1,5° und 30° vorliegen.

Der restliche, den Direktlichtanteil Pt umgebende Anteil des Primärlichtstrahls P trifft auf den Leuchtstoffkörper 3 und wird teilkonvertiert als das gemischte weiße Konversionslicht Ps, S abgestrahlt, alternativ z.B. als vollkonvertiertes gelbes Sekundärlicht S. Das Konversionslicht Ps, S weist eine erheblich breitere Winkelverteilung auf als der Direktlichtanteil Pt.

Der Direktlichtanteil Pt des ursprünglichen Primärlichtes P, welcher den Leuchtstoff 3 ungehindert passiert, ist für eine effektive Lichtausbeute vorteilhafterweise kleiner als der Anteil des Primärlichts P, welcher auf den Leuchtstoffkörper 3 trifft, also geringer als 50%, insbesondere geringer als 40%, insbesondere geringer als 30%, insbesondere geringer als 20%, insbesondere geringer als 10%.

Der Direktlichtanteil Pt trifft nur auf eine erste optische Fläche in Form einer ersten Reflexionsfläche 5. Die erste Reflexionsfläche 5 ist schalenförmig ausgebildet, z.B. ellipsoid, hyperboloid, paraboloid, oder als multifacettierte Freiformfläche und ist spekular (spiegelnd) reflektierend. Insbesondere beleuchtet der Direktlichtanteil Pt bei intaktem Leuchtstoffkörper 3 nicht die gesamte erste Reflexionsfläche 5.

Die erste Reflexionsfläche 5 ist von einer weit größeren zweiten optischen Fläche in Form einer zweiten Reflexionsfläche 6 umgeben, welche ebenfalls schalenförmig, z.B. ellipsoid, hyperboloid, paraboloid, oder als multifacettierte Freiformfläche und spekular (spiegelnd) ausgebildet ist. Das von dem Leuchtstoffkörper 3 abgestrahlte Konversionslicht Ps, S trifft hauptsächlich (bevorzugt zu mindestens 90%, insbesondere zu 95%, insbesondere zu 99%) auf die zweite Reflexionsfläche 6, mag aber einen geringen Anteil auch auf die erste Reflexionsfläche 5 strahlen. Jedoch ist der Direktlichtanteil Pt an der ersten Reflexionsfläche 5 dominierend gegenüber dem Konversionslichtanteil bzw. der Anteil des Konversionslichts Ps, S vernachlässigbar. Das Konversionslicht bzw. das Mischlicht Ps, S und der Direktlichtanteil Pt werden aufgrund ihrer nur geringen Vermischung optisch separat geführt.

Mittels des Konversionslichts Ps, S mag insbesondere ein herkömmliches Lichtabstrahlmuster des Fahrzeugscheinwerfers 1 erzeugt werden, z.B. ein Abblendlicht, Fernlicht, Nebellicht usw. Der Direktlichtanteil Pt mag einen lokal begrenzten Bereich des Lichtabstrahlmusters zusätzlich beleuchten und dadurch beispielsweise weiter erhellen, oder ein gewünschtes Lichtabstrahlmuster oder eine gewünschte Farbeinstellung bewirken.

Die erste Reflexionsfläche 5 wird im speziellen so ausgeführt, dass im optischen Pfad hinter der ersten Reflexionsfläche 5 eine Winkelverteilung des Direktlichtanteils Pt vorliegt, die den Fahrzeugscheinwerfer 1 für einen Betrachter ungefährlich macht. Dies kann z.B. durch eine ausreichend starke Strahlverbreiterung erreicht werden, also dadurch, dass der Direktlichtanteil Pt in einen entsprechend großen Raumwinkel reflektiert wird. Bevorzugt bietet sich eine Reflexion des Direktlichtanteils Pt in solche Raumwinkel an, welche zumindest im Fernfeld (z.B. ab ca. 5 m bis 10 m vor dem Fahrzeugscheinwerfer 1) innerhalb des durch das Konversionslicht erzeugten Lichtabstrahlmusters liegen. Dadurch kann der Direktlichtanteil Pt einen Beitrag zu dem Lichtabstrahlmuster liefern. So mag dort eine Helligkeit erhöht werden. Auch mag die blaue Farbe des Direktlichtanteils Pt eine Sichtbarkeit von angestrahlten Objekten verbessern. Es ist vorteilhaft, wenn der Raumwinkel, in den der Direktlichtanteil Pt reflektiert wird, eine große horizontale Breite annimmt, was sich z.B. bei Lichtabstrahlmustern zur Erzeugung von Abblendlicht, Nebellicht oder Fernlicht leicht einrichten lässt.

Im Schadensfall wird ein größerer Anteil des Primärlichtstrahls P, ggf. sogar der ganze Primärlichtstrahl P, auf einen Reflektor 8 gestrahlt. In einer Variante ist die erste Reflexionsfläche 5 so groß, dass dann der ganze Primärlichtstrahl P darauf einfällt und in seiner Strahlintensität auf ein gewünschtes Maß reduzierbar ist. In einer anderen Variante trifft ein im Querschnitt außenliegender Teil des Primärlichtstrahls P auf die zweite Reflexionsfläche 6. Dies mag jedoch keine Gefährdung darstellen, falls der auf die zweite Reflexionsfläche 6 auftreffende Primärlichtanteil so schwach ist, dass er auch ohne die spezielle Reduzierung der Strahlintensität durch die erste Reflexionsfläche 5 bereits unterhalb eines kritischen Gefährdungsschwellwerts liegt.

Es wird besonders bevorzugt, dass im normalen Betrieb der Direktlichtanteil Pt und im Schadensfall der Primärlichtstrahl P gemäß Laserklasse 2, bevorzugt sogar gemäß Laserklasse 1, klassifiziert werden. Da die Größe des Lochs 4 und ggf. die Anzahl der Löcher 4 direkt zur Lichtleistung des Direktlichtanteils Pt beiträgt, mögen auch diese Parameter angepasst werden, um eine bestimmte Laserklasse für den Direktlichtanteil Pt zu erreichen.

Die erste Reflexionsfläche 5 ist in Bezug auf den Lichtlauf vor der zweiten Reflexionsfläche 6 und damit näher an dem Leuchtstoffkörper 3 angeordnet. Die beiden Reflexionsflächen 5 und 6 sind dadurch voneinander beabstandet und somit getrennt.

Je nach Bedarf mag zumindest die erste Reflexionsfläche 5 und/oder die zweite Reflexionsfläche 6 zumindest teilweise diffus reflektierend ausgebildet sein. Beispielsweise ist eine örtlich teilweise Mattierung der ersten Reflexionsfläche 5 und/oder der zweiten Reflexionsfläche 6 möglich. Zudem mag anstelle der ersten Reflexionsfläche 5 auch eine lichtabsorbierende Blende verwendet werden.

Die erste Reflexionsfläche 5 und/oder die zweite Reflexionsfläche 6 sind hier als Flächen eines gemeinsamen Bauteils, nämlich eines Reflektors 8, ausgeführt.

Der Leuchtstoffkörper 3 ist parallel zu einer optischen Achse A der zweiten Reflexionsfläche 6 ausgerichtet. Es ist auch möglich, den Leuchtstoffkörper 3 in einem Winkel zu der optischen Achse A anzuordnen, um z.B. eine Sammeleffizienz des Reflektors 8 zu erhöhen oder um bauraumtechnischen Verhältnissen Rechnung zu tragen.

Das Loch 4 befindet sich bevorzugt an einem Brennfleck der ersten Reflexionsfläche 5, während der das Konversionslicht Ps, S abstrahlende Leuchtstoffkörper 3 sich vorzugsweise in einem Bereich eines Brennflecks der zweiten Reflexionsfläche 6 befindet.

**Fig.2** zeigt den Reflektor 8 des Fahrzeugscheinwerfers 1 von vorne (von rechts in Fig.1). Die erste Reflexionsfläche 5 ist nun elliptisch ausgebildet gezeigt, um einen ebenfalls im Querschnitt elliptisch geformten Direktlichtanteil Pt vollständig, aber ohne Flächenverlust, in das Fernfeld umlenken zu können. Die elliptische Form bietet sich insbesondere bei einem typischerweise elliptischen Primärlichtstrahl P eines einzelnen Lasers 2 an.

Grundsätzlich können der Laser 2 und die erste Reflexionsfläche 5 aber auch anders ausgerichtet sein, z.B. um einen beliebigen Winkel verdreht sein, z.B. um 90° um eine Hauptabstrahlrichtung.

Eine große Halbachse H der ersten Reflexionsfläche 5 mag insbesondere so ausgerichtet sein, dass bei einer direkten Abbildung des Direktlichtanteils Pt dieses in dem Lichtabstrahlmuster zu einem breiten Bereich beiträgt, z.B. in Bezug auf eine horizontale Ausdehnung einer Abblendlicht- oder Fernlicht-Lichtverteilung.

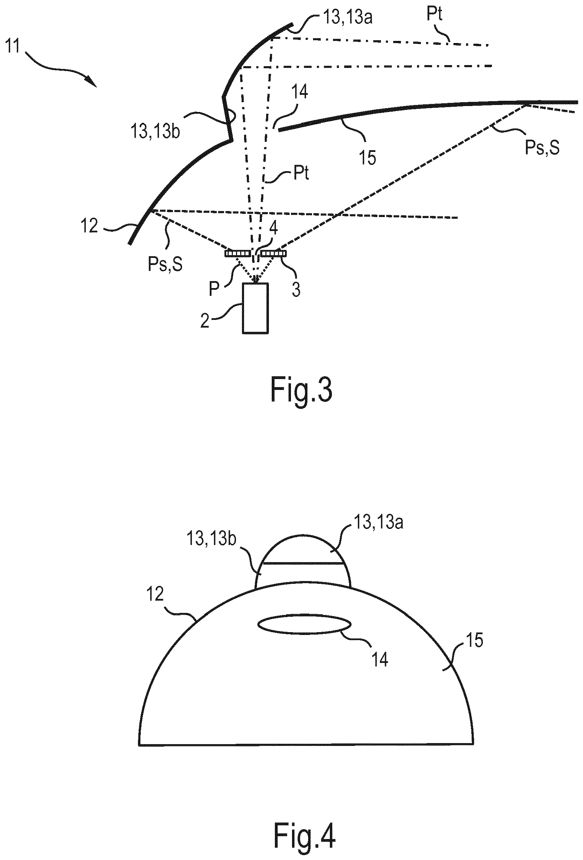

**Fig.3** zeigt als Schnittdarstellung in Seitenansicht eine Leuchtvorrichtung 11 gemäß einem zweiten Ausführungsbeispiel mit einem Reflektor 12. **Fig.4** zeigt den Reflektor 12 in einer Ansicht von vorne.

Die Leuchtvorrichtung 11 weist einen gleichen Grundaufbau auf wie die Leuchtvorrichtung 1, wobei nun jedoch eine erste Reflexionsfläche 13 hinter einer Aussparung 14 einer zweiten Reflexionsfläche 15 angeordnet ist. Die Aussparung 14 mag z.B. kreisförmig oder elliptisch geformt sein.

Die erste Reflexionsfläche 13 mag ähnlich zu der ersten Reflexionsfläche 5 der Leuchtvorrichtung 1 geformt sein, beispielsweise schalenförmig, z.B. ellipsoid, hyperboloid oder paraboloid. Die zweite Reflexionsfläche 15 mag ähnlich zu der zweiten Reflexionsfläche 6 der Leuchtvorrichtung 1 geformt sein, beispielsweise schalenförmig, z.B. ellipsoid, hyperboloid oder paraboloid.

Dieses Ausführungsbeispiel ermöglicht auf besonders einfache Weise eine räumliche Trennung des von der ersten Reflexionsfläche 13 abgestrahlten Direktlichtanteils Pt und des von der zweiten Reflexionsfläche 15 abgestrahlten Konversionslichts Ps, S, da die von ihnen reflektierte Strahlung Pt bzw. Ps, S zumindest abschnittsweise durch den Reflektor 12 getrennt ist. Dies mag beispielsweise dazu genutzt werden, den Direktlichtanteils Pt ohne Beeinflussung des Konversionslichts Ps, S weiter zu formen und ggf. sogar ganz zu blockieren, z.B. mittels einer nur dem Direktlichtanteil Pt zugeordneten Optik (o. Abb.). Diese Optik mag beispielsweise mindestens eine Blende, mindestens eine Linse, mindestens einen Reflektor usw. umfassen.

Die erste Reflexionsfläche 13 mag zwei Teilbereiche 13a und 13b aufweisen, wobei ein erster Teilbereich 13a von dem Direktlichtanteil Pt bestrahlt wird und ein zweiter Teilbereich 13b nicht von dem Direktlichtanteil Pt bestrahlt wird. Der zweite Teilbereich 13b befindet sich vielmehr im Normalbetrieb außerhalb des Direktlichtanteils Pt und im Schadensfall parallel zu einer Strahlrichtung am Rand des Primärlichtstrahls P. Der zweite Teilbereich 13b, welcher auch nicht reflektierend ausgebildet sein mag, dient stattdessen vorwiegend als Träger oder Befestigung des ersten Teilbereichs 13a. Durch die außenliegende Beabstandung der ersten Reflexionsfläche 13a von der zweiten Reflexionsfläche 15 wird es vorteilhafterweise ermöglicht, dass der von dem ersten Teilbereich 13a reflektierte Direktlichtanteil Pt nicht durch den Reflektors 12 abgeschattet wird. Auch wird so eine vielgestaltbare Strahlführung erreicht.

Allgemein mag jedoch auf den zweiten Teilbereich 13b verzichtet werden, so dass dann die außen angeordnete erste Reflexionsfläche 13 vollständig von dem Direktlichtanteil Pt bestrahlt wird bzw. der erste Teilbereich 13a direkt an der Aussparung 14 ansetzt.

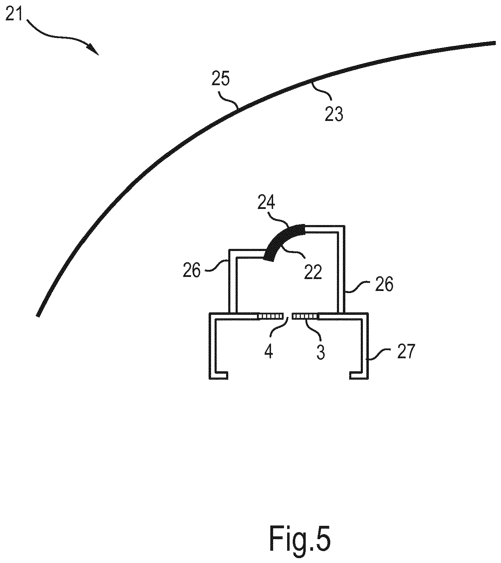

**Fig.5** zeigt als Schnittdarstellung in Seitenansicht eine Leuchtvorrichtung 21 gemäß einem dritten Ausführungsbeispiel ohne den Laser 2.

Während bei den Leuchtvorrichtungen 1 und 11 die erste Reflexionsfläche 5 bzw. 13 und die zweite Reflexionsfläche 6 bzw. 15 einem gemeinsamen Reflektor 8 bzw. 12 zugehörig sind, z.B. einstückig hergestellt worden sind, gehören bei der Leuchtvorrichtung 21 die erste Reflexionsfläche 22 und die zweite Reflexionsfläche 23 zu unterschiedlichen Bauteilen. Ein die erste Reflexionsfläche 22 bereitstellender erster Reflektor 24 ist nun zwischen dem Leuchtstoffkörper 3 und einem nur die zweite Reflexionsfläche 23 bereitstellenden zweiten Reflektor 25 angeordnet. Der erste Reflektor 24 wird mittels einer Halterung oder eines Gerüsts 26 gehalten, das vorzugsweise zur Geringhaltung eines Lichtverlusts aus lichtdurchlässigem (transparentem oder transluzentem) Material, insbesondere Kunststoff, besteht. Das Gerüst 26 mag mit einer Halterung 27 für den Leuchtstoffkörper 3 verbunden sein. Die Halterung 27 besteht zur randseitigen Wärmeableitung von dem Leuchtstoffkörper 3 vorzugweise aus Metall und mag z.B. mit einem Kühlkörper (o. Abb.) verbunden sein

Das Gerüst 26 und die Halterung 27 mögen fest miteinander verbunden sein, z.B. miteinander verklemmt, verrastet und/oder verklebt. Das Gerüst 26 mag zusätzlich oder alternativ mit einer Halterung des Lasers 2 oder dessen primärer Optik (o. Abb.) verbunden sein.

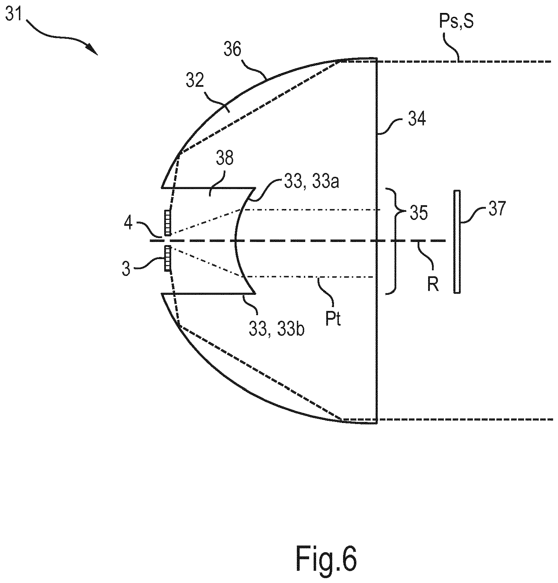

**Fig.6** zeigt als Schnittdarstellung in Seitenansicht eine Leuchtvorrichtung 31 gemäß einem vierten Ausführungsbeispiel ohne den Laser 2. Hier werden das von dem Leuchtstoffkörper 3 abgestrahlte Konversionslichts Ps, S und der durch das Loch 4 durchgestrahlte Direktlichtanteil Pt in ein refraktives optisches Element 32 eingestrahlt. Das refraktive optische Element 32 mag beispielsweise das an einer z.B. rückwärtigen Lichteintrittsfläche 33 einfallende Licht Pt, Ps, S zum Durchtritt an z.B. einer vorderseitigen Lichtaustrittsfläche 34 parallelisieren, fokussieren und/oder richten. Das refraktive optische Element 32 mag beispielsweise als ein sphärischer, paraboloider oder hyperboloider Rotationskörper mit einer Rotationsachse R ausgebildet sein.

Die Lichteintrittsfläche 33 mag beispielsweise einer Oberfläche eines zentrisch um die Rotationsachse R angeordneten Rücksprungs 38 entsprechen. Die Lichteintrittsfläche 33 lässt sich in zwei unterschiedliche Teilbereiche 33a und 33b unterteilen, welche eine unterschiedliche Grundform aufweisen. Nur ein erster, zentrisch um die Rotationsachse R ausgebildeter und konvexer Teilbereich 33a wird von dem Direktlichtanteil Pt bestrahlt. Der dort eingestrahlte Direktlichtanteil Pt durchläuft das refraktive optische Element 32 und tritt maximal an der Lichtaustrittsfläche 34 in einem um die Rotationsachse R zentrierten Zentralbereich 35 wieder aus.

Ist der Leuchtstoffkörper 3 nicht beschädigt, wird nur ein Teil des ersten Teilbereichs 33a bestrahlt, so dass dann der Direktlichtanteil Pt auch nicht an dem ganzen Zentralbereich 35 austritt. Ist der Leuchtstoffkörper 3 hingegen nicht mehr vorhanden, wird beispielsweise der ganze erste Teilbereich 33a von dem Direktlichtanteil Pt bestrahlt. Der erste Teilbereich 33a mag eine linsenartige Strahlformung bewirken. An einem Rand des ersten Teilbereichs 33a schließt sich ein z.B. hohlzylindrischer, z.B. zentrisch um die Rotationsachse R liegender zweiter Teilbereich 33b an. Die Rotationssymmetrie und/oder die zentrische Anordnung sind jedoch nicht zwingend. So mag es bei nicht runden oder nicht quadratischen Lichtquellen bevorzugt sein, dass die Form nicht rotationssymmetrisch ist. Auch mag z.B. der zweite Teilbereich 33b einer Freiformfläche entsprechen.

Das Konversionslicht Ps, S strahlt sowohl auf den ersten Teilbereich 33a als auch, insbesondere zu einem größeren Anteil, auf den zweiten Teilbereich 33b. Das Konversionslicht Ps, S mag an einer Seitenfläche 36 beispielsweise durch innere Totalreflexion reflektiert werden. In einer Variante mag in einem Schadensfall ein Randbereich des Direktlichtanteils Pt, welcher insbesondere bereits eine unschädliche Strahlungsintensität aufweist, auf den zweiten Teilbereich 33b einfallen.

In einer Variante mag dem Zentralbereich 35 ein optisches Element 37 nachgeschaltet sein. Dieses mag als ein separat hergestelltes Element vorliegen, das auf der Lichtaustrittsfläche 34 aufliegt, oder, wie gezeigt, davon beabstandet angeordnet ist. Das optische Element 37 mag alternativ als eine auf den Zentralbereich 35 aufgebrachte Beschichtung vorliegen. Das optische Element 37 mag als Blende ausgebildet sein, welches das aus dem Zentralbereich 35 austretende Licht absorbiert. Das optische Element 37 mag alternativ als Diffusor (Diffusorplatte, Diffusorschicht o.ä.) vorliegen, um das aus dem Zentralbereich 35 austretende Licht großflächig aufzufächern und so seine Intensität zu reduzieren. Es mag z.B. auch eine Linse sein, welche das aus dem Zentralbereich 35 austretende Licht so weit verbreitert, insbesondere in horizontaler Richtung, dass es unschädlich wird.

Die gezeigte Lichtaustrittsfläche 34 ist als eine plane Fläche dargestellt, ist jedoch nicht darauf beschränkt. So mag sie z.B. auch eine optisch wirksame Struktur aufweisen, beispielsweise ein Fresnel-Muster oder ein Feld von refraktiven (Mikro-)Linsenbereichen.

Anstelle einer um die Rotationsachse R vollständig rotationssymmetrischen Anordnung mag das refraktive optische Element 32 auch eine im Querschnitt zu der Rotationsachse R elliptische Form aufweisen. Dies mag insbesondere vorteilhaft sein, falls der Primärlichtstrahl P eine im Querschnitt elliptische Form aufweist.

Obwohl die Erfindung im Detail durch die gezeigten Ausführungsbeispiele näher illustriert und beschrieben wurde, so ist die Erfindung nicht darauf eingeschränkt und andere Variationen können vom Fachmann hieraus abgeleitet werden, ohne den Schutzumfang der Ansprüche zu verlassen.

So mag ein von dem Laser abgestrahlter Lichtstrahl in der Ebene des Leuchtstoffkörpers bzw. in dem Loch noch konvergieren bzw. eine zusammenlaufende Form aufweisen. Er mag danach, aber noch vor einem Auftreffen auf eine Reflexionsfläche, wieder divergieren.

Auch können zur Strahlformung des Lichts unterschiedliche optische Elemente verwendet werden, beispielsweise ein Schalenreflektor zur Reflexion nur des Konversionslichts und ein refraktives optisches Element zum Strahlformen des Direktlichtanteils.

Auch können zur Bestrahlung des Leuchtstoffkörpers mehrere Halbleiterlichtquellen, insbesondere Laser, gleicher oder unterschiedlicher Frequenz verwendet werden. Die Primärlichtstrahlen können über geeignete optische Anordnungen, z.B. TIR-Optiken oder Spiegelelemente, zusammengeführt und auf das Konversionselement gerichtet werden. Auch können ein oder mehrere Halbleiterlichtquellen so ausgerichtet bzw. fokussiert werden, dass sie bevorzugt den Mittenbereich des Konversionselements ausleuchten; andere Halbleiterlichtquellen können dann Randbereiche des Leuchtstoffkörpers ausleuchten. Diejenigen Halbleiterlichtquellen, die auf den Mittenbereich des Leuchtstoffkörpers ausgerichtet bzw. fokussiert sind, mögen eine andere Strahlungsfrequenz emittieren als diejenigen Halbleiterlichtquellen, die die Außenbereiche des Leuchtstoffkörpers bestrahlen. Die Halbleiterlichtquellen können im Dauerbetrieb und /oder getaktet betrieben werden.

Allgemein kann bei den gezeigten Ausführungsbeispielen mindestens ein weiteres optisches Element nachgeschaltet sein, z.B. für eine Abbildung des Lichtabstrahlmusters in eine Umgebung, insbesondere in ein Fernfeld. Dieses mindestens eine weitere optische Element mag beispielsweise mindestens ein refraktive Element wie eine Linse, mindestens eine Blende, mindestens einen Reflektor usw. umfassen. Die in den Ausführungsbeispielen gezeigten Leuchtvorrichtungen sind insbesondere mit Fahrzeugen verwendbar, insbesondere als Fahrzeugscheinwerfer oder mit Fahrzeugscheinwerfern.

Allgemein kann unter "ein", "eine" usw. eine Einzahl oder eine Mehrzahl verstanden werden, insbesondere im Sinne von "mindestens ein" oder "ein oder mehrere" usw., solange dies nicht explizit ausgeschlossen ist, z.B. durch den Ausdruck "genau ein" usw.

Auch kann eine Zahlenangabe genau die angegebene Zahl als auch einen üblichen Toleranzbereich umfassen, solange dies nicht explizit ausgeschlossen ist.

### Bezugszeichen

- 1: Leuchtvorrichtung
- 2: Laser
- 3: Leuchtstoffkörper
- 4: Loch
- 5: Erste Reflexionsfläche
- 6: Zweite Reflexionsfläche
- 8: Reflektor
- 11: Leuchtvorrichtung
- 12: Reflektor
- 13: Erste Reflexionsfläche
- 13a: Teilbereich
- 13b: Teilbereich
- 14: Aussparung
- 15: Zweite Reflexionsfläche
- 21: Leuchtvorrichtung
- 22: Erste Reflexionsfläche
- 23: Zweite Reflexionsfläche
- 24: Erster Reflektor
- 25: Zweiter Reflektor
- 26: Gerüst
- 27: Halterung
- 31: Leuchtvorrichtung
- 32: Optisches Element
- 33: Lichteintrittsfläche
- 33a: Erster Teilbereich
- 33b: Zweiter Teilbereich
- 34: Lichtaustrittsfläche
- 35: Zentralbereich
- 36: Seitenfläche
- 37: Optisches Element
- 38: Rücksprung
- A: Optische Achse
- H: Halbachse
- P: Primärlichtstrahl
- Ps: Primärlicht
- Pt: Direktlichtanteil
- R: Rotationsachse
- S: Sekundärlicht
- th: Halber Öffnungswinkel

## Patentansprüche

1. Leuchtvorrichtung (1; 11; 21; 31), aufweisend mindestens eine Lichtquelle (2), insbesondere Halbleiterlichtquelle, zur Aussendung eines Primärlichtstrahls (P) auf mindestens einen beabstandeten Leuchtstoffkörper (3), **dadurch gekennzeichnet, dass** der Leuchtstoffkörper (3) mindestens ein Loch (4) aufweist und ein Direktlichtanteil (Pt) des jeweiligen Primärlichtstrahls (P) durch das mindestens eine Loch (4) durchstrahlbar ist.

2. Leuchtvorrichtung (1; 11; 21; 31) nach Anspruch 1, wobei der Direktlichtanteil (Pt) einen Teil höchster Leistungsdichte des Primärlichtstrahls (P) umfasst.

3. Leuchtvorrichtung (1; 11; 21; 31) nach einem der vorhergehenden Ansprüche, wobei der Direktlichtanteil (Pt) bei symmetrischer Querschnittsform einen halben Öffnungswinkel zwischen 0,5° und 15° aufweist.

4. Leuchtvorrichtung (1; 11; 21; 31) nach einem der Ansprüche 1 bis 3, wobei der Direktlichtanteil (Pt) bei asymmetrischer Querschnittsform einen kleinsten halben Öffnungswinkel zwischen 0,5° und 15° und einen größten halben Öffnungswinkel zwischen 1,5° und 30° aufweist.

5. Leuchtvorrichtung (1; 11; 21; 31) nach einem der vorhergehenden Ansprüche, wobei von dem Leuchtstoffkörper (3) abgestrahltes Konversionslicht (Ps, S) und der Direktlichtanteil (Pt) optisch separat geführt sind.

6. Leuchtvorrichtung (1; 11; 21) nach Anspruch 5, wobei der Direktlichtanteil (Pt) nur auf mindestens eine erste, insbesondere reflektierende, optische Fläche (5; 13, 13a; 22) trifft und das Konversionslicht (Ps, S) mindestens auf eine zweite, insbesondere reflektierende, optische Fläche (6; 15; 23) trifft, wobei die mindestens eine erste optische Fläche (5; 13, 13a; 22) so ausgestaltet ist, dass sie eine Strahlungsintensität des Direktlichtanteils (Pt) reduziert.

7. Leuchtvorrichtung (1; 21) nach Anspruch 6, wobei die mindestens eine erste optische Fläche (5; 22) in Bezug auf den Leuchtstoffkörper (3) vor der mindestens einen zweiten optischen Fläche (6; 23) angeordnet ist.

8. Leuchtvorrichtung (11) nach Anspruch 6, wobei die mindestens eine erste optische Fläche (13, 13a) in Bezug auf den Leuchtstoffkörper (3) hinter einer Aussparung (14) in der mindestens einen zweiten optischen Fläche (15) angeordnet ist.

9. Leuchtvorrichtung (1; 11) nach einem der vorhergehenden Ansprüche, wobei die mindestens eine erste optische Fläche (5; 13, 13a) und die mindestens eine zweite optische Fläche (6; 15) einem gemeinsamen Bauteil (8; 12) zugehörig sind.

10. Leuchtvorrichtung (21) nach einem der Ansprüche 1 bis 8, wobei die mindestens eine erste optische Fläche (22) und die mindestens eine zweite optische Fläche (23) unterschiedlichen Bauteilen (24, 25) zugehörig sind.

11. Leuchtvorrichtung (1) nach einem der vorhergehenden Ansprüche, wobei von dem Leuchtstoffkörper (3) abgestrahltes Konversionslicht (Ps, S) und der Direktlichtanteil (Pt) in ein refraktives optisches Element (32) einstrahlbar sind.

12. Leuchtvorrichtung (1) nach einem der vorhergehenden Ansprüche, wobei die Leuchtvorrichtung (1) ein Fahrzeugscheinwerfer oder ein Teil davon ist.

13. Fahrzeugscheinwerfer, aufweisend mindestens eine Leuchtvorrichtung (1) nach einem der vorhergehenden Ansprüche.

## Claims

1. Luminaire (1; 11; 21; 31), comprising at least one light source (2), in particular a semiconductor light source, for emitting a primary light beam (P) onto at least one spaced-apart luminescent body (3), **characterized in that** the luminescent body (3) comprises at least one hole (4) and a direct light component (Pt) of the respective primary light beam (P) can be radiated through the at least one hole (4).

2. Luminaire (1; 11; 21; 31) according to Claim 1, wherein the direct light component (Pt) comprises a part of highest power density of the primary light beam (P).

3. Luminaire (1; 11; 21; 31) according to any one of the preceding claims, wherein the direct light component (Pt) has a half aperture angle between 0.5° and 15° with symmetrical cross-sectional form.

4. Luminaire (1; 11; 21; 31) according to any one of Claims 1 to 3, wherein the direct light component (Pt) has a least half aperture angle between 0.5° and 15° and a greatest half aperture angle between 1.5° and 30° with asymmetrical cross-sectional form.

5. Luminaire (1; 11; 21; 31) according to any one of the preceding claims, wherein conversion light (Ps, S) emitted by the luminescent body (3) and the direct light component (Pt) are optically guided separately.

6. Luminaire (1; 11; 21) according to Claim 5, wherein the direct light component (Pt) is only incident on at least one first, in particular reflective, optical surface (5; 13, 13a; 22) and the conversion light (Ps, S) is incident at least on a second, in particular reflective, optical surface (6; 15; 23), wherein the at least one first optical surface (5; 13, 13a; 22) is embodied so that it reduces a radiation intensity of the direct light component (Pt).

7. Luminaire (1; 21) according to Claim 6, wherein the at least one first optical surface (5; 22) is arranged in front of the at least one second optical surface (6; 23) with respect to the luminescent body (3).

8. Luminaire (11) according to Claim 6, wherein the at least one first optical surface (13, 13a) is arranged behind an opening (14) in the at least one second optical surface (15) with respect to the luminescent body (3).

9. Luminaire (1; 11) according to any one of the preceding claims, wherein the at least one first optical surface (5; 13, 13a) and the at least one second optical surface (6; 15) are associated with a common component (8; 12).

10. Luminaire (21) according to any one of Claims 1 to 8, wherein the at least one first optical surface (22) and the at least one second optical surface (23) are associated with different components (24, 25).

11. Luminaire (1) according to any one of the preceding claims, wherein conversion light (Ps, S) emitted from the luminescent body (3) and the direct light component (Pt) can be radiated into a refractive optical element (32).

12. Luminaire (1) according to any one of the preceding claims, wherein the luminaire (1) is a vehicle headlight or a part thereof.

13. Vehicle headlight, comprising at least one luminaire (1) according to any one of the preceding claims.

## Revendications

1. Dispositif d'éclairage (1 ; 11 ; 21 ; 31), présentant au moins une source lumineuse (2), en particulier une source lumineuse à semi-conducteurs, pour l'émission d'un rayon lumineux primaire (P) sur au moins un corps luminescent (3) placé à distance, **caractérisé en ce que** le corps luminescent (3) présente au moins un orifice (4) et une composante lumineuse directe (Pt) du rayon lumineux primaire respectif (P) peut traverser l'au moins un orifice (4).

2. Dispositif d'éclairage (1 ; 11 ; 21 ; 31) selon la revendication 1, dans lequel la composante lumineuse directe (Pt) englobe une partie de densité de puissance la plus élevée du rayon lumineux primaire (P).

3. Dispositif d'éclairage (1 ; 11 ; 21 ; 31) selon l'une des revendications précédentes, dans lequel la composante lumineuse directe (Pt) présente, pour une forme de section transversale symétrique, un demi-angle d'ouverture entre 0,5° et 15°.

4. Dispositif d'éclairage (1 ; 11 ; 21 ; 31) selon l'une des revendications 1 à 3, dans lequel la composante lumineuse directe (Pt) présente, pour une forme de section transversale asymétrique, un plus petit demi-angle d'ouverture entre 0,5° et 1° et un plus grand demi-angle d'ouverture entre 1,5° et 30°.

5. Dispositif d'éclairage (1 ; 11 ; 21 ; 31) selon l'une des revendications précédentes, dans lequel la lumière de conversion (Ps, S) émise par le corps luminescent (3) et la composante lumineuse directe (Pt) sont optiquement séparées.

6. Dispositif d'éclairage (1 ; 11 ; 21) selon la revendication 5, dans lequel la composante lumineuse directe (Pt) rencontre uniquement au moins une première surface optique (5 ; 13, 13a ; 22) en particulier réfléchissante et la lumière de conversion (Ps, S) rencontre au moins une deuxième surface optique (6 ; 15 ; 23) en particulier réfléchissante, dans lequel l'au moins une première surface optique (5 ; 13, 13a ; 22) est aménagée de sorte à réduire une intensité de rayonnement de la composante lumineuse directe (Pt).

7. Dispositif d'éclairage (1 ; 21) selon la revendication 6, dans lequel l'au moins une première surface optique (5 ; 22) est disposée, par rapport au corps luminescent (3), avant l'au moins une deuxième surface optique (6 ; 23).

8. Dispositif d'éclairage (11) selon la revendication 6, dans lequel l'au moins une première surface optique (13 ; 13a) est disposée, par rapport au corps luminescent (3), derrière un évidement (14) dans l'au moins une deuxième surface optique (15).

9. Dispositif d'éclairage (1 ; 11) selon l'une des revendications précédentes, dans lequel l'au moins une première surface optique (5 ; 13, 13a) et l'au moins une deuxième surface optique (6 ; 15) appartiennent à un composant commun (8 ; 12).

10. Dispositif d'éclairage (21) selon l'une des revendications 1 à 8, dans lequel l'au moins une première surface optique (22) et l'au moins une deuxième surface optique (23) appartiennent à des composants différents (24, 25).

11. Dispositif d'éclairage (1) selon l'une des revendications précédentes, dans lequel la lumière de conversion (Ps, S) émise par le corps luminescent (3) et la composante lumineuse directe (Pt) peuvent être émises dans un élément optique réfractif (32).

12. Dispositif d'éclairage (1) selon l'une des revendications précédentes, dans lequel le dispositif d'éclairage (1) est un phare d'automobile ou une partie de celui-ci.

13. Phare d'automobile présentant au moins un dispositif d'éclairage (1) selon l'une des revendications précédentes.
